# EUROPEAN PATENT APPLICATION

(11) **EP 2 767 518 A1**
(43) Date of publication of application: **20.08.2014**
(21) Application number: 12839916.9
(22) Date of filing: 10.10.2012
(51) Int. Cl.: C03C 8/16, C03C 17/04, H01L 51/50, H05B 33/02, H05B 33/10

(54) **GLASS FOR USE IN SCATTERING LAYER OF ORGANIC LED ELEMENT, MULTILAYER SUBSTRATE FOR USE IN ORGANIC LED ELEMENT AND METHOD FOR PRODUCING SAID MULTILAYER SUBSTRATE, AND ORGANIC LED ELEMENT AND METHOD FOR PRODUCING SAME**

(30) Priority: 14.10.2011 JP 2011226947
(71) Applicant: Asahi Glass Company, Limited, Chiyoda-ku Tokyo 100-8405 (JP)
(72) Inventor: WADA, Naoya, Tokyo 100-8405 (JP); TANIDA, Masamichi, Tokyo 100-8405 (JP)
(74) Representative: Müller-Boré & Partner Patentanwälte PartG mbB
(86) International application number: PCT/JP2012/076238
(87) International publication number: WO 2013/054820

(57) **Abstract**

Glass for a scattering layer of an organic LED includes, as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅, and a total amount of B₂O₃-content and ZnO-content is 78% or less.

## Description

### TECHNICAL FIELD

The present invention relates to glass for a scattering layer of an organic LED element, a laminated substrate for the organic LED element and a method of manufacturing the same, and an organic LED element and a method of manufacturing the same.

### BACKGROUND ART

Conventionally, it is known to provide a scattering layer within an organic LED element in order to improve a light extraction efficiency of the organic LED element (for example, refer to Patent Document 1). The scattering layer includes a scattering material dispersed within a base material that is made of glass. This scattering layer is formed by coating glass powder (glass frits) on a translucent substrate and sintering the glass powder.

### PRIOR ART DOCUMENTS

### PATENT DOCUMENTS

Patent Document 1: International Publication No. 2011/046156 pamphlet

### DISCLOSURE OF THE INVENTION

### PROBLEM TO BE SOLVED BY THE INVENTION

In a case in which the glass uneasily flows when sintering the glass frits, the surface of the scattering layer becomes rough, and electrodes formed on the scattering layer may become short-circuited.

Fluidity of the glass at the time of the sintering is determined by a sintering temperature, a glass-transition temperature, crystallizability of glass, and the like. The glass more easily flows as the sintering temperature becomes higher relative to the glass-transition temperature.

However, an upper limit of the sintering temperature is determined by a heat resistance and the like of the translucent substrate. In addition, glass having a low glass-transition temperature tends to easily crystalize at the time of the sintering, and the fluidity of the glass considerably deteriorates when the crystallization occurs. Hence, it is difficult to improve the fluidity of the glass at the time of the sintering by simply lowing the glass-transition temperature. Further, the surface becomes rough when the crystallization occurs. For this reason, the surface roughness of the scattering layer has room for improvement. The Patent Document 1 has no specific disclosure with regard to the above described problem.

The present invention is conceived in view of the above described problem, and one object is to provide glass for a scattering layer of an organic LED element, a laminated substrate for the organic LED element and a method of manufacturing the same, and an organic LED element and a method of manufacturing the same, in which the surface roughness of the scattering layer can be reduced.

### MEANS OF SOLVING THE PROBLEM

In order to achieve the above object, glass for a scattering layer of an organic LED element in an embodiment (1) of the present invention is characterized in that there are provided:
as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅; and
a total amount of B₂O₃-content and ZnO-content is 78% or less.

A method of manufacturing a laminated substrate for an organic LED element having a translucent substrate and a scattering layer in an embodiment (2) of the present invention is characterized in that:
the scattering layer includes, within a base material made of glass, a scattering material having a refractive index different from that of the glass and dispersed within the base material, and is formed by sintering a raw material including the glass; and
the glass includes, as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅, and a total amount of B₂O₃-content and ZnO-content is 78% or less.

A laminated substrate for an organic LED element having a translucent substrate and a scattering layer in an embodiment (3) of the present invention is characterized in that:
the scattering layer includes, within a base material made of glass, a scattering material having a refractive index different from that of the glass and dispersed within the base material; and
the glass includes, as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅, and a total amount of B₂O₃-content and ZnO-content is 78% or less.

A method of manufacturing an organic LED element having a translucent substrate, a scattering layer, a first electrode, an organic layer, and a second electrode in this order in an embodiment (4) of the present invention is characterized in that:
the scattering layer includes, within a base material made of glass, a scattering material having a refractive index different from that of the glass and dispersed within the base material, and is formed by sintering a raw material including the glass; and
the glass includes, as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅, and a total amount of B₂O₃-content and ZnO-content is 78% or less.

An organic LED element having a translucent substrate, a scattering layer, a first electrode, an organic layer, and a second electrode in this order in an embodiment (5) of the present invention is characterized in that:
the scattering layer includes, within a base material made of glass, a scattering material having a refractive index different from that of the glass and dispersed within the base material; and
the glass includes, as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅, and a total amount of B₂O₃-content and ZnO-content is 78% or less.

### EFFECTS OF THE INVENTION

According to the present invention, glass for a scattering layer of an organic LED element, a laminated substrate for the organic LED element and a method of manufacturing the same, and an organic LED element and a method of manufacturing the same are provided, in which the surface roughness of the scattering layer can be reduced.

### BRIEF DESCRIPTION OF THE DRAWING

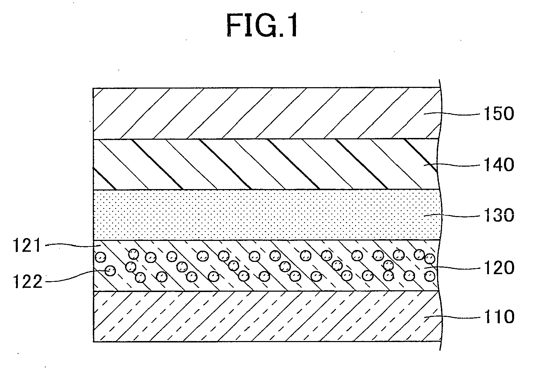

FIG. 1 is a cross sectional view illustrating an organic LED element in an embodiment of the present invention.

### MODE OF CARRYING OUT THE INVENTION

A description will hereinafter be given of embodiments of the present invention with reference to the drawings. The following embodiments are examples, and various variations and modifications may be made without departing from the object of the present invention.

FIG. 1 is a cross sectional view illustrating an organic LED element in an embodiment of the present invention.

As illustrated in FIG. 1, the organic LED element is a bottom emission type organic LED, for example, and includes a translucent substrate 110, a scattering layer 120, a first electrode 130, an organic layer 140, and a second electrode 150 in this order. The first electrode 130 is an anode to supply holes to the organic layer 140, and may be a transparent electrode that transmits light emitted from the organic layer 140 towards the scattering layer 120. The second electrode 150 is a cathode to supply electrons to the organic layer 140, and may be a reflecting electrode that reflects the light emitted from the organic layer 140 towards the organic layer 140.

In this embodiment, the first electrode 130 is the anode and the second electrode 150 is the cathode, however, the first electrode 130 may be the cathode and the second electrode 150 may be the anode.

### (Translucent Substrate)

The translucent substrate 110 is made of a material having a high transmittance with respect to visible light. For example, the translucent substrate 110 may be a glass substrate or a plastic substrate, however, because the plastic substrate may become deformed at the time of sintering the glass frits, it is preferable to use the glass substrate.

The glass used for the glass substrate may be alkali glass, borosilicate glass, fused silica, and the like. Generally, alkali silicate glass such as soda-lime glass is used. A general alkali silicate glass substrate has an average linear thermal expansion coefficient at 50°C to 300°C (hereinafter simply referred to as "average linear thermal expansion coefficient") of approximately 83 x 10⁻⁷/°C, and an annealing temperature of approximately 550°C to approximately 630°C. Because the glass substrate may become deformed when subjected to a heat treatment at a temperature higher than or equal to the annealing temperature, it is preferable to form the scattering layer 120 at a temperature lower than the annealing temperature.

The plastic substrate has a low moisture resistance compared to the glass substrate, and may thus be configured to include a barrier. For example, a glass layer may be formed on a surface of the plastic substrate, opposite to the surface provided with the scattering layer 120.

The translucent substrate 110 has a thickness of 0.1 mm to 2.0 mm, for example.

The scattering layer 120 is formed on the translucent substrate 110, and a laminated substrate is formed by the translucent substrate 110, the scattering layer 120, and the like. A scattering layer forming surface of the glass substrate forming the translucent substrate 110 may be subjected to a surface treatment such as silica coating and the like. In other words, a protection layer formed by a silica layer and the like may be formed between the glass substrate forming the translucent substrate 110 and the scattering layer 120. Details of the scattering layer 120 will be described later. The first electrode 130 is formed on the scattering layer 120.

### (First Electrode)

The first electrode 130 is the anode to supply the holes to the organic layer 140, and forms the transparent electrode that transmits the light emitted from the organic layer 140 towards the scattering layer 120. The first electrode 130 is formed by a material having a high work function and a high transmittance (for example, a transmittance of 80% or higher).

Materials used for the first electrode 130 include ITO (Indium Tin Oxide), SnO₂, ZnO, IZO (Indium Zinc Oxide), AZO (ZnO-Al₂O₃: aluminum-doped zinc oxide), GZO (ZnO-Ga₂O₃: gallium-doped zinc oxide), N-doped TiO₂, Ta-doped TiO₂, and the like.

The first electrode 130 has a thickness of 50 nm or greater, for example. The electrical resistance becomes high when the thickness of the first electrode 130 is less than 50 nm.

The first electrode 130 has a refractive index of 1.7 to 2.2, for example. A carrier concentration of ITO may be increased in order to reduce the refractive index of the ITO forming the first electrode 130. The higher the Sn concentration of ITO, the lower the refractive index of the ITO. However, as the Sn concentration increases, mobility and transmittance decrease, and the Sn concentration is set to balance the mobility and transmittance.

In this specification, "refractive index" refers to the refractive index that is measured at 25°C using d-line (wavelength: 587.6 nm) of a He lamp, unless otherwise indicated.

The first electrode 130 may be made up of a single layer or made up of a plurality of layers. In addition, an auxiliary wiring may be formed to make contact with the first electrode 130 at a part above the first electrode or at a part under the first electrode 130. Materials used for the auxiliary wiring may include metals such as Au, Ag, Cu, Al, Cr, Mo, Pt, W, Ni, Ru, and the like, metal compounds, and the like.

The organic layer 140 is formed on the first electrode 130.

### (Organic Layer)

The organic layer 140 may have a general configuration including at least an emissive layer, and may include a hole injecting layer, a hole transport layer, an electron transport layer, and an electron injecting layer if necessary. For example, the organic layer 140 includes, from the anode side, the hole injecting layer, the hole transport layer, the emissive layer, the electron transport layer, and the electron injecting layer in this order.

The hole injecting layer is formed by a material having a small ionization potential difference with respect to the anode. Polyethylene dioxythiophene (PEDOT:PSS) and the like, doped with polystyrene sulfonic acid (PSS), are used as the high-molecular-weight material. Phthalocyanenes such as copper phthalocyanene (CuPc) and the like are used as the low-molecular-weight material.

The hole transport layer transports the holes injected from the hole injecting layer to the emissive layer. Materials used for the hole transport layer include a triphenylamine derivative, N,N'-Bis(1-naphthyl)-N,N'-Diphenyl-1,1'-biphenyl-4,4'-diamine (NPD), N,N'-Diphenyl-N,N'-Bis[N-phenyl-N-(2-naphtyl)-4'-aminobiphenyl-4-yl]-1,1'-biphenyl-4,4'-diamine (NPTE), 1,1'-bis[(di-4-tolylamino)phenyl]cyclohexane (HTM2), and N,N'-Diphenyl-N,N'-Bis(3-methylphenyl)-1,1'-diphenyl-4,4'-diamine (TPD), and the like, for example. The hole transport layer preferably has a thickness of 10 nm to 150 nm. The thinner the hole transport layer, the lower the voltage, however, the thickness of the hole transport layer is preferably 10 nm to 150 nm in view of the problem of the electrodes that may become short-circuited.

The emissive layer emits light using energy that is generated by recombination of the holes and the electrons injected from the anode and the cathode. Doping of emissive dye to a host material forming the emissive layer enables a high emission efficiency to be obtained, and also converts an emission wavelength. Organic materials used for the emission layer include low-molecular weight materials and high-molecular-weight materials. In addition, the organic materials are categorized into fluorescent materials and phosphorescent materials depending on the emission mechanism. The organic materials forming the emissive layer include, for example, a metal complex of quinoline derivative, such as tris(8-quinolinolate) aluminum complex (Alq₃), bis(8-hydroxy) quinaldine aluminum phenoxide (Alq'20Ph), bis(8-hydroxy) quinaldine aluminum-2,5-dimethylphenoxide (BAlq), mono(2,2,6,6-tetramethyl-3,5-heptanedionate)lithium complex (Liq), mono(8-quinolinolate)sodium complex (Naq), mono(2,2,6,6-tetramethyl-3,5-heptanedionate) lithium complex, mono(2,2,6,6-tetramethyl-3,5-heptanedionate) sodium complex, bis(8-quinolinolate) calcium complex (Caq₂), and the like, or a fluorescent substance, such as tetraphenylbutadiene, phenylquinacridone (QD), anthracene, perylene, coronene, and the like. The host material is preferably a quinolinolate complex, and an aluminum complex having 8-quinolinol and a derivative thereof as a ligand is particular preferable.

The electron transport layer transports the electrons injected from the electrode. Materials used for the electron transport layer include, for example, a quinolinol aluminum complex (Alq₃), an oxadiazole derivative (for example, 2,5-bis(1-naphthyl)-1,3,4-oxadiazole (END), 2-(4-t-butylphenyl)-5-(4-biphenyl)-1,3,4-oxadiazole (PBD) and the like), a triazole derivative, a bathophenanthroline derivative, a silole derivative, and the like.

The electron injecting layer may be a layer doped with an alkali metal such as lithium (Li), cesium (Cs), and the like to the cathode surface, for example.

The second electrode 150 is formed on the organic layer 140.

### (Second Electrode)

The second electrode 150 is the cathode to supply the electrons to the organic layer 140, and forms the reflecting electrode that reflects the light emitted from the organic layer 140 towards the organic layer 140. The second electrode 150 is formed by a metal having a small work function, or an alloy of such a metal.

Materials used for the second electrode 150 include alkali metals, alkaline earth metals, metals in group 3 of the periodic table, and the like, for example. Aluminum (Al), magnesium (Mg), silver (Ag), alloys of such metals, and the like may be used for such materials.

For example, the second electrode 150 may be a codeposited layer of MgAg, a laminated electrode having Al deposited on a thin film deposition of LiF or Li₂O, or an electrode having aluminum (Al) stacked on a layer of alkaline earth metal (for example, Ca or Ba).

### (Scattering Layer)

The scattering layer 120 is provided between the translucent substrate 110 and the first electrode 130. Generally, the refractive index of the translucent substrate 110 is lower than the refractive index of the first electrode 130, and in a state in which no scattering layer 120 is provided, total reflection occurs and there exists a large portion of the light that cannot be extracted to the outside. The scattering layer 120 changes propagating directions of such light by scattering, in order to increase the light extraction efficiency with which the light can be extracted to the outside.

As illustrated in FIG. 1, the scattering layer 120 includes a scattering material 122 having a refractive index different from that of glass, dispersed within a base material 121 made of glass. The scattering layer 120 is formed by sintering a raw material (for example, paste) including the glass. The raw material may include the scattering material 122. In a case in which the scattering material 122 is a gas such as air, the gas need not be included in the raw material, and the gas may be introduced into the glass at the time of the sintering.

The refractive index of the base material 121 at a predetermined wavelength is preferably higher than or equal to the refractive index of the first electrode 130. In this case, the light extraction efficiency with which the light is extracted to the outside is improved, because total reflection of light having the predetermined wavelength does not occur at an interface between the first electrode 130 and the scattering layer 120. The predetermined wavelength may be at least a part (for example, red, blue, or green) of a wavelength range of the light emitted from the organic layer 140, and is preferably the entire region (430 nm to 650 nm) of the wavelength range of the emitted light, and more preferably the entire region (360 nm to 830 nm) of the wavelength range of visible light.

A difference between the refractive index of the base material 121 and the refractive index of the scattering material 122 is preferably 0.05 or greater at the predetermined wavelength described above.

A surface roughness Ra of the scattering layer 120 is preferably 100 nm or less, more preferably 90 nm or less, and further preferably 80 nm or less. When the surface roughness Ra of the scattering layer 120 exceeds 100 nm, the short-circuiting of the first electrode 130 and the second electrode 150 formed on the surface of the scattering layer 120 may occur, and a leak current may be generated. The surface roughness Ra is a microscopically observed surface roughness having a value that is obtained by eliminating a long-wavelength component by setting a cutoff value λc of a profile filter prescribed by JIS B 0601-2001 to 2.5 mm, and can be measured by an atomic force microscope (AFM) and the like, for example.

### (Scattering Material)

The scattering material 122 has a refractive index different from that of the base material 121. Ceramic particles having low reaction with the base material 121, and shapes, dimensions, and contents thereof that are easily controllable, are used for the scattering material 122. The ceramic particles may be formed by silica (SiO₂) , alumina (Al₂O₃), titania (TiO₂), zirconia (ZrO₂), and the like, for example. A plurality of kinds of ceramic particles may be used. Zirconia (ZrO₂) has a particularly good wettability with respect to the base material 121 at the time of the sintering, and can easily form a smooth surface, and thus, it is particularly preferable to use zirconia (ZrO₂) as the scattering material 122.

Besides the ceramic particles, glass having a composition different from that of the glass used for the base material 121, or a gas such as air and the like, may be used for the scattering material 122. The gas may be included in the scattering layer 120 in the form of bubbles.

A ratio of the scattering material 122 occupying the scattering layer 120 is appropriately set depending on the kind of the scattering material 122 used. In the case in which the ceramic particles are used for the scattering material 122, the ratio described above is preferably 1 volume % to 10 volume %. When the ratio described above is less than 1 volume %, sufficient scattering cannot be obtained in order to extract the light from the organic LED. On the other hand, when the ratio described above exceeds 10 volume %, the ceramic particles project from the surface of the sintered layer, and there is a possibility of increasing the short-circuit or the leak current of the organic LED.

In a case in which a plurality of kinds of scattering materials 122 are dispersed within the scattering layer 120, "the ratio of the scattering material 122 occupying the scattering layer 120" refers to a total of the ratios of all of the scattering materials 122.

The dimensions and shapes of the scattering material 122 are appropriately set depending on the kind of the scattering material 122. An average particle diameter (D50) of the ceramic particles used for the scattering material 122 is preferably 0.05 µm to 1 µm. When D50 is less than 0.05 µm, sufficient scattering cannot be obtained in order to extract the light from the organic LED, and because a wavelength dependency of the scattering intensity increases to make it difficult to control the scattering intensity, it becomes difficult to control the tone of color of the light that is extracted. On the other hand, when D50 is greater than 1 µm, sufficient scattering cannot be obtained in order to extract the light from the organic LED. D50 is the 50% diameter prescribed by JIS R 1629-1997.

In a case in which the ceramic particles are used, the refractive index of the scattering material 122 is preferably 1.8 or lower, or 2.1 or higher. When the refractive index of the ceramics is higher than 1.8 and lower than 2.1, sufficient extraction of light cannot be expected.

### (Base Material)

The glass (hereinafter referred to as "base material glass") forming the base material 121 is manufactured by mixing a plurality of kinds of glass raw materials at predetermined ratios, heating and melting the mixture, and thereafter cooling the mixture. The base material glass that is manufactured is broken into pieces by a mill, and classified if necessary, in order to obtain glass in powder form (glass frits). The glass frits are sintered in order to form the base material 121.

The base material glass preferably includes, as represented by mol percentage based on the following oxides, 26% to 43% and preferably 36% to 43% of B₂O₃, 30% to 37% of ZnO, 17% to 23% of Bi₂O₃, 2% to 21% and preferably 2% to 11% of SiO₂, and 0 to 2% of P₂O₅, and a total amount of the B₂O₃-content and the ZnO-content is 78% or less.

According to the glass composition described above, the average linear thermal expansion coefficient is small (difference from the average linear thermal expansion coefficient of an alkali silicate glass substrate is small), the refractive index is high, the glass-transition temperature is low, and the crystallization of glass at the time of sintering the glass frits can be suppressed. Because the glass-transition temperature is low and the crystal deposition can be suppressed, the fluidity of glass at the time of sintering the glass frits can be improved, and the surface roughness of the scattering layer 120 can be reduced. Each component will be described in the following. In the description of each component, "%" refers to mol %.

B₂O₃ is a component that forms the framework of the glass. The B₂O₃-content of the base material glass is 26% to 43%, and preferably 36% to 43%. When the B₂O₃-content of the base material glass is less than 26%, devitrification of the glass easily occurs at the time of the manufacture, and in addition, the glass easily crystallizes at the time of sintering the glass frits. On the other hand, when the B₂O₃-content of the base material glass exceeds 43%, the glass-transition temperature becomes high. In addition, when the B₂O₃-content of the base material glass exceeds 43%, the refractive index decreases and is thus not preferable.

ZnO is a component that stabilizes the glass. The ZnO-content of the base material glass is 30% to 37%. When the ZnO-content of the base material glass is less than 30%, the glass-transition temperature becomes high, and the linear thermal expansion coefficient becomes large. On the other hand, when ZnO-content of the base material glass exceeds 37%, devitrification of the glass easily occurs at the time of the manufacture, and in addition, the glass easily crystallizes at the time of sintering the glass frits. In addition, when ZnO-content of the base material glass exceeds 37%, the weather resistance of the glass may deteriorate.

A total amount of the B₂O₃-content and the ZnO-content of the base material glass is 78% or less. When the total amount of the B₂O₃-content and the ZnO-content of the base material glass exceeds 78%, the glass easily crystallizes at the time of sintering the glass frits.

Bi₂O₃ is a component that increases the refractive index and lowers the glass-transition temperature. The Bi₂O₃-content of the base material glass is 17% to 23%. When the Bi₂O₃-content of the base material glass is less than 17%, the refractive index becomes low, and the glass-transition temperature becomes high. On the other hand, when the Bi₂O₃-content of the base material glass exceeds 23%, the average linear thermal expansion coefficient becomes large, and the glass easily crystallizes at the time of sintering the glass frits.

SiO₂ is a component that increases the stability of the glass and suppresses the crystallization at the time of sintering the glass frits. The SiO₂-content of the base material glass is 2% to 21%, and preferably 2% to 11%. When the SiO₂-content of the base material glass is less than 2%, the glass easily crystallizes at the time of sintering the glass frits. On the other hand, when the SiO₂-content of the base material glass exceeds 21%, the dissolving temperature of the glass raw material becomes high, and deterioration and the like of a melter occurs, to thereby make it difficult to manufacture the glass.

P₂O₅ is an arbitrary component that suppresses crystallization at the time of sintering the glass frits. The P₂O₂-content of the base material glass is 0 to 2%. When the P₂O₂-content of the base material glass exceeds 2%, the glass-transition temperature becomes high, and the average linear thermal expansion coefficient becomes large. In addition, when the P₂O₂-content of the base material glass exceeds 2%, the refractive index decreases. Because the effect of P₂O₂ on the glass-transition temperature is large, it is preferable to include substantially no P₂O₂ except for cases in which P₂O₂ is included as an impurity.

Al₂O₃ is an arbitrary component that increases the stability of glass. The Al₂O₃-content of the base material glass is preferably 0 to 7%. When the Al₂O₃-content of the base material glass exceeds 7%, devitrification of the glass easily occurs at the time of the manufacture, and in addition, the glass easily crystallizes at the time of sintering the glass frits.

ZrO₂ is an arbitrary component that suppresses crystallization at the time of sintering the glass frits. The ZrO₂-content of the base material glass is preferably 0 to 7%. When the ZrO₂-content of the base material glass exceeds 7%, devitrification of the glass easily occurs at the time of the manufacture, and the glass-transition temperature may become high.

Gd₂O₃ is an arbitrary component that increases the refractive index while suppressing the average linear thermal expansion coefficient to a low value, and also suppresses crystallization at the time of sintering the glass frits. The Gd₂O₃-content of the base material glass is preferably 0 to 5%. When the Gd₂O₃-content of the base material glass exceeds 5%, crystallization of the glass may easily occur at the time of sintering the glass frits.

TiO₂ is a component that is not essential but increases the refractive index of the base material glass, and the TiO₂-content of the base material glass may be up to 5%. However, when the base material glass includes an excessive amount of TiO₂, crystallization of the glass may easily occur at the time of sintering the glass frits.

WO₃ is a component that is not essential but increases the refractive index of the base material glass, and the WO₃-content of the base material glass may be up to 5%. However, when the base material glass includes an excessive amount of WO₃, crystallization of the glass may easily occur at the time of sintering the glass frits.

Alkaline earth metal oxides (MgO, CaO, SrO, and BaO) are arbitrary components that decrease the glass-transition temperature. The content of the alkaline earth metal oxides in the base material glass is preferably 0 to 5%. When the content of the alkaline earth metal oxides in the base material glass exceeds 5%, the average linear thermal expansion coefficient becomes large, and crystallization of the glass may easily occur at the time of sintering the glass frits.

Substantially no Li₂O, Na₂O, and K₂O are included in the base material glass, except for cases in which Li₂O, Na₂O, and K₂O are included as impurities. When these alkaline metal oxides are included in the base material glass, alkali metal ions may scatter during a heat treatment process. The alkali metal ions may cause undesirable effects on the electrical operation of the organic LED element.

Substantially no PbO and Pb₃O₄ are included in the base material glass, except for cases in which PbO and Pb₃O₄ are included as impurities. Hence, it is possible to satisfy the needs of the user who wishes to avoid the use of lead.

The base material glass may include, within a range in which the effects of the invention are obtainable, GeO₂, Nb₂O₅, Y₂O₃, Ce₂O₃, CeO₂, La₂O₃, TeO₂, SnO, SnO₂, Sb₂O₃, Ta₂O₅, and the like, for example, which amount to a total of 5% or less. In addition, the base material glass may include a small amount of coloring agent in order to adjust the tone of color. Known coloring agents, such as transition metal oxides, rare earth metal oxides, metal colloids, and the like, may be used as the coloring agent. These coloring agents may be used independently or in combination.

A refractive index n_{d} of the base material glass is preferably 1.80 or higher, more preferably 1.85 or higher, and further preferably 1.90 or higher. When the refractive index n_{d} is lower than 1.8, the effect of the total reflection at the interface between the scattering layer 120 and the first electrode 130 is large, and the light extraction efficiency may easily deteriorate.

A glass transition temperature Tg of the base material glass is preferably 475°C or lower, more preferably 470°C or lower, and further preferably 465°C or lower. When the glass transition temperature Tg is 475°C or lower, the glass may easily flow at the time of sintering the glass frits in a case in which the sintering of the glass frits is performed at a temperature lower than or equal to the annealing temperature of the general glass substrate. In addition, the glass has a good wettability with respect to the ceramic particles of the scattering material 122 at the time of sintering the glass frits, and a good surface roughness of the scattering layer 120 can be obtained.

An average linear thermal expansion coefficient α of the base material glass is preferably 60 x 10⁻⁷/°C to 100 x 10⁻⁷/°C, and more preferably 70 x 10⁻⁷/°C to 90 x 10⁻⁷/°C. When the average linear thermal expansion coefficient α is within a range of 60 x 10⁻⁷/°C to 100 x 10⁻⁷/°C, a difference (absolute value) from the average linear thermal expansion coefficient of the alkali silicate glass substrate forming the translucent substrate 110 is small, and damage and warp to the substrate with respect to temperature changes can be reduced.

### (Method of Manufacturing Scattering Layer)

The scattering layer 120 is formed by coating the raw material (for example, paste) including the glass frits on the translucent substrate 110 and sintering this raw material. The raw material may include the scattering material 122. In a case in which the scattering material 122 is a gas such as air, the gas need not be included in the raw material, and the gas may be introduced into the glass at the time of the sintering.

### (1) Glass Frits

The glass frits are powders of the base material glass. D50 of the base material glass powder is preferably 1 µm to 10 µm from the standpoint of coating ease. Surface modification of the base material glass powder may be made using a surfactant or a silane coupling agent.

### (2) Paste

The paste is made by mixing the ceramic particles of the scattering material 122 and vehicle, in addition to the glass frits. The coating ease onto the translucent substrate 110 is improved by mixing the vehicle. In a case in which the scattering material 122 is formed by a gas, the glass frits and the vehicle are mixed to make the paste. The paste does not need to include air bubbles, because the air bubbles may be formed at the time of sintering the paste.

The paste is obtained by mixing the glass frits, the ceramic particles, and the vehicle in a planetary mixer and the like, and uniformly dispersing the paste by a triple roll mill and the like. A solvent and the like may be added and further mixed in the mixer, in order to adjust the viscosity. The paste is obtained by mixing a total of 70 mass % to 80 mass % of the glass frits and the ceramic particles to 20 mass % to 30 mass % of the vehicle, at this proportion.

The vehicle is a mixture of a resin and a solvent, and further mixed with a surfactant. The vehicle is obtained by mixing the resin, the surfactant, and the like to the solvent that is heated to 50°C to 80°C, for example, and filtering the mixture after resting the mixture for 4 hours to 12 hours.

The resin retains the shape of a coating layer of the paste. Examples of the resin include ethyl cellulose, nitrocellulose, acrylic resin, vinyl acetate, butyral resin, melamine resin, alkyd resin, rosin resin, and the like. Ethyl cellulose, nitrocellulose, and the like may be used as a base resin. The strength of the coating layer may be improved by adding butyral resin, melamine resin, alkyd resin, or rosin resin.

The solvent has a function to dissolve the resin and to adjust the viscosity. The solvent preferably does not dry during the coating and dries quickly during the drying, and preferably has a boiling temperature of 200°C to 230°C. Examples of the solvent include an ether type solvent (butyl carbitol (BC), butyl carbitol acetate (BCA), diethylene glycol di-n-butyl ether, dipropylene glycol butyl ether, tripropylene glycol butyl ether, butyl cellosolve acetate, an alcohol type solvent (α-terpineol, pine oil, Dowanol), an ester type solvent (2,2,4-trimethyl-1,3-pentanediol monoisobutyrate), a phthalic acid ester type solvent (DBP (dibutyl phthalate), DMP (dimethyl phthalate), DOP (dioctyl phthalate)), and the like. These solvents may be used independently or in combination in order to adjust the viscosity, the content ratio, and the drying speed. Generally, α-terpineol or 2,2,4-trimethyl-1,3-pentanediol monoisobutyrate is mainly used as the solvent. Further, DBP (dibutyl phthalate, DMP (dimethyl phthalate), and DOP (dioctyl phthalate) also function as a plasticizer.

A method of coating the paste on the translucent substrate 110 uses screen printing, doctor blade printing, dye-coat printing, and the like. It is also possible to use a method that creates a green sheet by coating the paste on a base material that is separate from the translucent substrate 110 and drying the paste, and separating the green sheet from the base material and bonding the green sheet on the translucent substrate 110 by thermocompression bonding.

In a case in which the screen printing is used, the thickness of the coating layer can be controlled by adjusting a mesh size of a screen stencil, the thickness of an emulsion, a pressing force at the time of printing, a pushing amount of a squeegee, and the alike.

In a case in which the doctor blade printing or the dye-coat printing is used, the coating layer can be made thicker compared to the case in which the screen printing is used.

The coating layer may be made thicker by repeating the coating and drying.

### (4) Sintering

Sintering of the coating layer of the paste includes a decomposing process to decompose and eliminate the resin within the paste, and a softening process to soften the glass frits after the decomposing process. The decomposing process is performed at atmospheric conditions for 20 minutes to 1 hour, by heating at 350°C to 400°C in the case in which ethyl cellulose is used for the resin, and at 200°C to 300°C in the case in which nitrocellulose is used for the resin. The softening process is preferably performed at atmospheric conditions for 20 minutes to 1 hour, by heating at a temperature of the glass-transition temperature Tg+100°C to the glass-transition temperature Tg+150°C. By heating at such a temperature, the fluidity of the glass becomes high, and a part of the scattering material is unlikely to project from the surface of the glass layer even when the ceramic particles are used for the scattering material, to thereby enable a smooth surface to be formed. Even when heated at such a temperature, the glass-transition temperature Tg is sufficiently low and the crystallization uneasily occurs, and thus, a high fluidity of the glass can be obtained when compared to the conventional case, while suppressing thermal deformation of the translucent substrate 110 in a manner similar to the conventional case. By cooling to room temperature after the sintering, the scattering layer 120 is formed on the translucent substrate 110. In a case in which the fluidity of the glass is to be further increased at the softening process, the softening process is preferably performed at a temperature of the glass-transition temperature Tg+130°C to the glass-transition temperature Tg+150°C.

### Embodiments

The present invention is specifically described in the following in conjunction with embodiments, however, the present invention is not limited to the following embodiments.

### (Experiment 1)

In Example 1 through Example 31, molten glass is created to obtain glass having compositions illustrated in Table 1 through Table 5, by combining glass raw materials such as B₂O₃, ZnO, Bi₂O₃, SiO₂, Al₂O₃, ZrO₂, and the like, in a platinum melting pot, and heating at 1200°C for 1.5 hours. The glass raw material includes substantially no alkaline metal oxides (Li₂O, Na₂O, and K₂O), lead (PbO, Pb₃O₄), nor P₂O₅. Example 1 through Example 23 and Example 26 through Example 31 are embodiments, and Example 24 and Example 25 are comparison examples.

A part of the molten glass is poured into a carbon mold to create bulk glass. In order to remove distortions, the bulk glass is heated at 490°C for 1 hour using an electric furnace, and thereafter annealed to room temperature using 5 hours. Samples for measuring the refractive index, and samples (cylindrical column having a diameter of 5 mm and a length of 200 mm) for measuring the glass-transition temperature and the average linear thermal expansion coefficient are created from the glass after the annealing.

The refractive index n_{d} is measured using a refractometer (KPR-2000 manufactured by Kalnew) using the V-block method. The refractive index n_{d} is measured at 25°C using the d-line (wavelength: 587.6 nm) of the He lamp.

The glass-transition temperature Tg (°C) and the average linear thermal expansion coefficient α (10⁻⁷/°C) are measured using a thermal expansion meter (TD5000SA manufactured by Bruker AXS). The temperature raising speed is 5°C/min. The average linear thermal expansion coefficient α is the average linear thermal expansion coefficient at 50°C to 300°C.

The remaining part of the molten glass is poured between a pair of rolls and quenched, to create flake-shaped glass. The flake-shaped glass is broken into pieces by dry milling of a planetary ball mill for 2 hours, and particles having a particle diameter of 0.6 µm or less and particles having a particle diameter of 5.0 µm or greater are both removed using an elbow-jet classifier. The average particle diameter (D50) of the glass powder obtained is 1.5 µm when measured using a laser diffraction type particle size distribution measuring apparatus (SALD-2100 manufactured by Simadzu Corporation).

The existence of crystals at the surface of the sintered layer is observed and evaluated by coating and sintering the glass frits on the alkali silicate glass substrate (PD200 manufactured by Asahi Glass Company, Limited at an annealing temperature of 620°C) to form the glass layer, and observing and evaluating the surface of the glass layer using an optical microscope. First, the paste is created by mixing 75g of glass frits and 25g of organic vehicle (10 mass % of ethyl cellulose dissolved into α-terpineol). Next, the paste is screen-printed in a range of 35 mm x 35 mm on the alkali silicate glass substrate (PD200 manufactured by Asahi Glass Company, Limited) having a size of 100 mm x 100 mm and a thickness of 1.8 mm, dried for 30 minutes at 150°C, once returned to room temperature and then raised to a temperature of 475°C in 48 minutes, and held at 475°C for 30 minutes, in order to decompose and eliminate the resin of the organic vehicle. Thereafter, the temperature is raised to each glass-transition temperature indicated in Table 1 through Table 4 plus 130°C (578°C in Example 1) in 10 minutes, the temperature is held at the raised temperature (578°C in Example 1) for 40 minutes to soften the glass, and the temperature is thereafter lowered to room temperature in 3 hours in order to form the glass layer. The thickness of the glass layer that is formed is 15 µm. With regard to the crystals at the surface, "0" indicates the glass layer whose surface has no crystals recognizable on the optical microscope, and "X" indicates the glass layer whose surface has crystals recognizable on the optical microscope. Generally, for the same glass composition, the higher the sintering temperature the more easily the crystallization occurs. In addition, generally, for the same glass composition, glass powder having a particle diameter of several µm more easily crystallizes compared to glass powder having a particle diameter of several tens of µm.

The surface roughness Ra of the glass layer is measured using an atomic force microscope (Surfcorder ET4000A manufactured by Kosaka Laboratory Ltd.). The cutoff wavelength is set to 2.5 mm to eliminate the long wavelength component caused by undulation. Measurements are made in a region at a central part (5 mm x 5 mm) on the scattering layer surface (35 mm x 35 mm).

Evaluation results are illustrated in Table 1 through Table 5.

**Table 1**

| | Example 1 | Example 2 | Example 3 | Example 4 | Example 5 | Example 6 | Example 7 |
|---|---|---|---|---|---|---|---|
| B₂O₃ (mol %) | 39.5 | 42.0 | 37.0 | 39.5 | 39.1 | 42.5 | 38.3 |
| Bi₂O₃ (mol %) | 21.7 | 21.7 | 21.7 | 18.7 | 21.5 | 21.7 | 21.1 |
| ZnO (mol %) | 33.8 | 33.8 | 33.8 | 36.8 | 33.5 | 30.8 | 32.8 |
| SiO₂ (mol %) | 5.0 | 2.5 | 7.5 | 5.0 | 5.0 | 5.0 | 7.8 |
| Al₂O₃ (mol %) | 0.0 | 0.0 | 0.0 | 0.0 | 0.0 | 0.0 | 0.0 |
| ZrO₂ (mol %) | 0.0 | 0.0 | 0.0 | 0.0 | 0.0 | 0.0 | 0.0 |
| TiO₂ (mol %) | 0.0 | 0.0 | 0.0 | 0.0 | 0.0 | 0.0 | 0.0 |
| B₂O₃+ZnO (mol %) | 73.3 | 75.8 | 70.8 | 76.3 | 72.6 | 73.3 | 71.1 |
| n_{d} | 1.95 | 1.95 | 1.95 | 1.91 | 1.96 | 1.94 | 1.94 |
| Tg (°C) | 448 | 444 | 446 | 454 | 440 | 453 | 453 |
| α (10⁻⁷/°C) | 81 | 81 | 82 | 79 | 85 | 84 | 79 |
| Crystals at Surface | O | O | O | O | O | O | O |
| Ra (nm) | 76 | 59 | - | 42 | - | - | - |

**Table 2**

| | Example 8 | Example 9 | Example 10 | Example 11 | Example 12 | Example 13 | Example 14 |
|---|---|---|---|---|---|---|---|
| B₂O₃ (mol %) | 38.5 | 38.5 | 38.3 | 38.5 | 38.5 | 42.5 | 37.2 |
| Bi₂O₃ (mol %) | 21.2 | 21.2 | 18.2 | 18.2 | 18.2 | 18.7 | 20.4 |
| ZnO (mol %) | 33.0 | 33.0 | 35.7 | 35.9 | 35.9 | 33.8 | 31.8 |
| SiO₂ (mol %) | 4.9 | 4.9 | 7.8 | 4.9 | 4.9 | 5.0 | 10.6 |
| Al₂O₃ (mol %) | 2.4 | 0.0 | 0.0 | 2.5 | 0.0 | 0.0 | 0.0 |
| ZrO₂ (mol %) | 0.0 | 2.4 | 0.0 | 0.0 | 2.5 | 0.0 | 0.0 |
| TiO₂ (mol %) | 0.0 | 0.0 | 0.0 | 0.0 | 0.0 | 0.0 | 0.0 |
| B₂O₃+ZnO (mol %) | 71.5 | 71.5 | 74 | 74.4 | 74.4 | 76.3 | 69 |
| n_{d} | 1.94 | 1.95 | 1. 91 | 1.91 | 1.91 | 1.91 | 1.92 |
| Tg (°C) | 453 | 453 | 461 | 459 | 462 | 462 | 458 |
| α (10⁻⁷/°C) | 82 | 84 | 77 | 78 | 78 | 77 | 80 |
| Crystals at Surface | O | O | O | O | O | O | O |
| Ra (nm) | - | - | - | - | - | - | - |

**Table 3**

| | Example 15 | Example 16 | Example 17 | Example 18 | Example 19 | Example 20 | Example 21 |
|---|---|---|---|---|---|---|---|
| B₂O₃ (mol %) | 37.2 | 38.5 | 38.5 | 38.5 | 39.5 | 41.0 | 40.6 |
| Bi₂O₃ (mol %) | 17.6 | 18.2 | 19.7 | 18.2 | 20.2 | 19.5 | 19.3 |
| ZnO (mol %) | 34.6 | 35.9 | 34.4 | 35.9 | 35.3 | 34.5 | 34.2 |
| SiO₂ (mol %) | 10.6 | 6.4 | 6.4 | 7.4 | 5.0 | 5.0 | 5.9 |
| Al₂O₃ (mol %) | 0.0 | 1.0 | 1.0 | 0.0 | 0.0 | 0.0 | 0.0 |
| ZrO₂ (mol %) | 0.0 | 0.0 | 0.0 | 0.0 | 0.0 | 0.0 | 0.0 |
| TiO₂ (mol %) | 0.0 | 0.0 | 0.0 | 0.0 | 0.0 | 0.0 | 0.0 |
| B₂O₃+ZnO (mol %) | 71.8 | 74.4 | 72.9 | 74.4 | 74.8 | 75.5 | 74.8 |
| n_{d} | 1.90 | 1.91 | 1.92 | 1.91 | 1.93 | 1.92 | 1.92 |
| Tg (°C) | 465 | 460 | 454 | 462 | 453 | 458 | 462 |
| α (10⁻⁷/°C) | 74 | 77 | 79 | 76 | 80 | 79 | 79 |
| Crystals at Surface | O | O | O | O | O | O | O |
| Ra (nm) | - | 60 | 24 | - | - | - | 53 |

**Table 4**

| | Example 22 | Example 23 | Example 24 | Example 25 |
|---|---|---|---|---|
| B₂O₃ (mol %) | 37.2 | 37.2 | 41.0 | 40.2 |
| Bi₂O₃ (mol %) | 20.5 | 20.5 | 20.0 | 13.3 |
| ZnO (mol %) | 31.9 | 31.9 | 39.0 | 42.5 |
| SiO₂ (mol %) | 4.7 | 4.7 | 0.0 | 0.8 |
| Al₂O₃ (mol %) | 5.7 | 0.0 | 0.0 | 3.2 |
| ZrO₂ (mol %) | 0.0 | 5.7 | 0.0 | 0.0 |
| TiO₂ (mol %) | 0.0 | 0.0 | 0.0 | 0.0 |
| B₂O₃+ZnO (mol %) | 69.1 | 69.1 | 80.0 | 82.7 |
| n_{d} | - | - | 1.93 | 1.84 |
| Tg (°C) | 462 | 462 | 447 | 476 |
| α (10⁻⁷/°C) | 76 | 79 | 81 | 70 |
| Crystals at Surface | O | O | X | X |
| Ra (nm) | - | - | 459 | 135 |

**Table 5**

| | Example 26 | Example 27 | Example 28 | Example 29 | Example 30 | Example 31 |
|---|---|---|---|---|---|---|
| B₂O₃ (mol %) | 32.4 | 34.4 | 32.4 | 29.6 | 35.4 | 26.4 |
| Bi₂O₃ (mol %) | 19.3 | 17.3 | 17.3 | 19.4 | 19.3 | 19.3 |
| ZnO (mol %) | 34.2 | 34.2 | 36.2 | 36.9 | 31.2 | 34.2 |
| SiO₂ (mol %) | 14.1 | 14.1 | 14.1 | 14.1 | 14.1 | 20.1 |
| B₂O₃+ZnO (mol %) | 66.6 | 68.6 | 68.6 | 66.5 | 66.6 | 60.6 |
| n_{d} | 1.92 | 1.90 | 1.90 | 1.93 | 1.91 | 1.92 |
| Tg (°C) | 462 | 467 | 465 | 455 | 467 | 462 |
| α (10⁻⁷/°C) | 75 | 71 | 73 | 76 | 73 | 72 |

From Table 1 through Table 5, it is confirmed that the glass in each of Example 1 through Example 23 and Example 26 through Example 31 has a high refractive index, softening property at low temperatures, and a low coefficient of thermal expansion. In addition, the glass in each of Example 1 through Example 23 and Example 26 through Example 31 has the glass-transition temperature Tg of 475°C or lower, and no crystals observed at the surface of the glass layer formed by the sintered layer, and thus, the surface roughness Ra of the sintered layer is significantly smaller compared to that of the glass in each of Example 24 and Example 25.

### (Experiment 2)

In Example 32 through Example 40, the paste is coated and sintered on the alkali silicate glass substrate to form the scattering layer, in a manner similar to Example 21, except that a part of the glass frits is replaced by the ceramic particles illustrated in Table 6 when creating the paste, and the surface roughness of the scattering layer is evaluated. In Example 34, the paste is coated and sintered on the alkali silicate glass substrate to form the scattering layer, in a manner similar to Example 24, except that a part of the glass frits is replaced by the ceramic particles illustrated in Table 6 when creating the paste, and the surface roughness of the scattering layer is evaluated. Evaluation results are illustrated in Table 7. In Table 7, "Ratio" indicates a ratio (volume %) of the ceramic particles occupying the scattering layer. In addition, in Table 7, "Glass A" indicates the glass having the composition of Example 21, and "Glass B" indicates the glass having the composition of Example 24. Example 32 through Example 39 are embodiments, and Example 40 is a comparison example.

**Table 6**

| Ceramic Particles | SiO₂ | ZrO₂ | TiO₂ |
|---|---|---|---|
| n_{d} | 1.5 | 2.4 | 2.7 |
| Average Particle Diameter D50 (µm) | 0.82 | 0.61 | 0.84 |

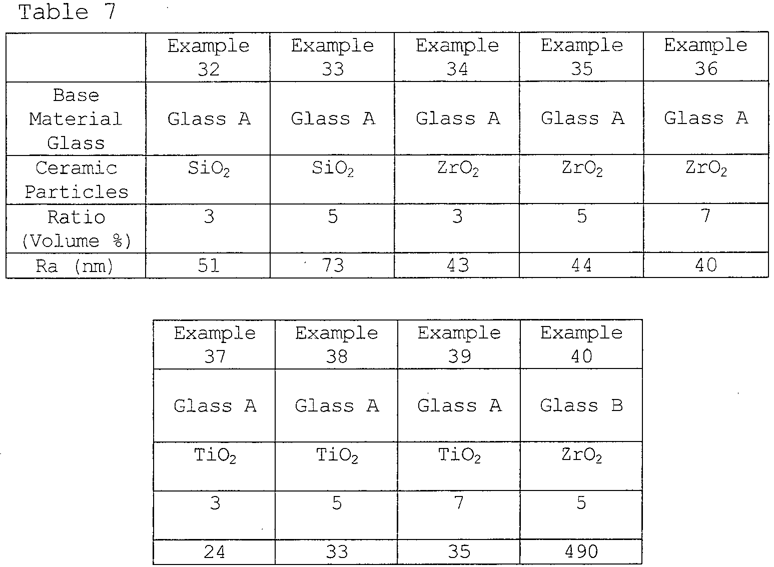

From Table 7, it is confirmed that the scattering layer in each of Example 32 through Example 39 has a good surface roughness Ra, similar to that of the sintered layer of Example 21. On the other hand, it is confirmed that the scattering layer of Example 40 has a large surface roughness Ra, and is unsuited for forming the organic LED.

### INDUSTRIAL APPLICABILITY

The present invention is suited for the glass for the scattering layer of the organic LED element, the laminated substrate for the organic LED element and the method of manufacturing the same, and the organic LED element and the method of manufacturing the same.

This application is based on a Japanese Patent Application No. 2011-226947 filed on October 14, 2011 to the Japan Patent Office, the disclosure of which is hereby incorporated by reference.

### DESCRIPTION OF REFERENCE NUMERALS

- 110: Translucent Substrate
- 120: Scattering Layer
- 130: First Electrode
- 140: Organic Layer
- 150: Second Electrode

## Claims

1. Glass for a scattering layer of an organic LED element, **characterized in that** there are provided:
as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅; and
a total amount of B₂O₃-content and ZnO-content is 78% or less.

2. The glass for the scattering layer of the organic LED element as claimed in claim 1, including substantially no alkaline metal oxides (Li₂O, Na₂O, and K₂O), lead (PbO, Pb₃O₄), nor P₂O₅, except for being included as an impurity.

3. A method of manufacturing a laminated substrate for an organic LED element having a translucent substrate and a scattering layer, **characterized in that**:
the scattering layer includes, within a base material made of glass, a scattering material having a refractive index different from that of the glass and dispersed within the base material, and is formed by sintering a raw material including the glass; and
the glass includes, as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅, and a total amount of B₂O₃-content and ZnO-content is 78% or less.

4. The method of manufacturing the laminated substrate of the organic LED element as claimed in claim 3, wherein the glass includes substantially no alkaline metal oxides (Li₂O, Na₂O, and K₂O), lead (PbO, Pb₃O₄), nor P₂O₅, except for being included as an impurity.

5. The method of manufacturing the laminated substrate of the organic LED element as claimed in claim 3 or 4, wherein the scattering layer is formed by sintering the raw material at a temperature higher than or equal to a glass-transition temperature of the glass plus 100°C.

6. The method of manufacturing the laminated substrate of the organic LED element as claimed in any of claims 3 to 5, wherein the scattering material includes ceramic particles.

7. The method of manufacturing the laminated substrate of the organic LED element as claimed in claim 6, wherein an average particle diameter of the ceramic particles is 1 µm or less.

8. The method of manufacturing the laminated substrate of the organic LED element as claimed in claim 6 or 7, wherein a ratio of the ceramic particles occupying the scattering layer is 5 volume % or less.

9. A laminated substrate for an organic LED element having a translucent substrate and a scattering layer, **characterized in that**:
the scattering layer includes, within a base material made of glass, a scattering material having a refractive index different from that of the glass and dispersed within the base material; and
the glass includes, as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅, and a total amount of B₂O₃-content and ZnO-content is 78% or less.

10. A method of manufacturing an organic LED element having a translucent substrate, a scattering layer, a first electrode, an organic layer, and a second electrode in this order, **characterized in that**:
the scattering layer includes, within a base material made of glass, a scattering material having a refractive index different from that of the glass and dispersed within the base material, and is formed by sintering a raw material including the glass; and
the glass includes, as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅, and a total amount of B₂O₃-content and ZnO-content is 78% or less.

11. The method of manufacturing the organic LED element as claimed in claim 10, wherein the glass includes substantially no alkaline metal oxides (Li₂O, Na₂O, and K₂O), lead (PbO, Pb₃O₄), nor P₂O₅, except for being included as an impurity.

12. The method of manufacturing the organic LED element as claimed in claim 10 or 11, wherein the scattering layer is formed by sintering the raw material at a temperature higher than or equal to a glass-transition temperature of the glass plus 100°C.

13. The method of manufacturing the organic LED element as claimed in any of claims 10 to 12, wherein the scattering layer includes ceramic particles.

14. The method of manufacturing the organic LED element as claimed in claim 13, wherein an average particle diameter of the ceramic particles is 1 µm or less.

15. The method of manufacturing the organic LED element as claimed in claim 13 or 14, wherein a ratio of the ceramic particles occupying the scattering layer is 10 volume % or less.

16. An organic LED element having a translucent substrate, a scattering layer, a first electrode, an organic layer, and a second electrode in this order, **characterized in that**:
the scattering layer includes, within a base material made of glass, a scattering material having a refractive index different from that of the glass and dispersed within the base material; and
the glass includes, as represented by mol percentage based on the following oxides, 26% to 43% of B₂O₃, 30% to 37% of ZnO, 17% to 23% of Bi₂O₃, 2% to 21% of SiO₂, and 0 to 2% of P₂O₅, and a total amount of B₂O₃-content and ZnO-content is 78% or less.
